# EUROPEAN PATENT APPLICATION

(11) **EP 4 213 116 A1**
(43) Date of publication of application: **19.07.2023**
(21) Application number: 22151608.1
(22) Date of filing: 14.01.2022
(51) Int. Cl.: G06V 40/13, G02B 3/00, H01L 27/146, G02B 27/30

(54) **COMPACT OPTICAL SENSOR**

(71) Applicant: WaveTouch Denmark A/S, 2630 Taastrup (DK); WaveTouch Limited, Hong Kong (HK)
(72) Inventor: Xue, Weiqi, 2630 Taastrup (DK); Korsgaard Jensen, Jørgen, 2630 Taastrup (DK)
(74) Representative: Høiberg P/S

(57) **Abstract**

The present disclosure relates to an optical sensor for use in an image recognition device, e.g. a biometric recognition system, such as a fingerprint detector or in image sensor applications / camera applications employing a pixel array where the individual pixels are large, e.g. flat panel detectors used for example in X-ray imaging. The presently disclosed optical sensor has improved light transmittance in a compact and cost-efficient structure. The presently disclosed compact optical setup makes it possible to employ a cost-efficient organic sensor for under-display-panel applications of an electronic device, such as a smartphone. One embodiment relates to an optical sensor system for detecting and/or imaging incident light, the optical sensor comprising a microlens structure having a front side with an array of light focusing elements and an opaque back side with an array of optically transparent apertures aligned with the focusing elements, and a sensor array of optical detector pixels facing the back side of the microlens structure, the optical sensor system is configured such that 1) light incident on the microlens structure can be focused by the microlens structure onto the sensor array through the transparent apertures, and 2) each optical detector pixel receives light from a plurality of the light focusing elements.

## Description

The present disclosure relates to an optical sensor for use in an image recognition device, e.g. a biometric recognition system, such as a fingerprint detector or in image sensor applications / camera applications employing a pixel array where the individual pixels are large, e.g. flat panel detectors used for example in X-ray imaging. The presently disclosed optical sensor has improved light transmittance in a compact and cost-efficient structure. The presently disclosed compact optical setup makes it possible to employ a cost-efficient organic sensor for under-display-panel applications of an electronic device, such as a smartphone.

### Background

Fingerprint sensors have been massively integrated in electronic devices with displays, such as smartphones, tablets, laptops, for privacy and data protection, as well as identity authentication. Today the most common fingerprint sensor is a capacitive sensor that works independent from the display of the device. The present move towards displays covering almost the entire front of the device makes it difficult to integrate the fingerprint sensor with the front surface because the capacitive sensors are not easily integrated with the electronics displays

Optical fingerprint sensors can be placed beneath the cover glass of the displays, because reflections from a finger can be scattered back through the cover glass and display to the fingerprint sensor. But in order to avoid a blurred image of the fingerprint, an optical fingerprint sensor typically needs to filter out large angle backscattered reflections from the finger before the light rays impinge the pixels of the sensor array.

Current filtering technologies provide light absorbing channels located between the display and the sensor arrays thereby functioning as collimators, see for example US 2017/270342 and US 2018/012069. In order to substantially filter out undesired background light, the thickness of the channels must be about 300 microns with a diameter of every channel of about 15 microns. Not only is the optical efficiency of such collimators poor, but also the fabrication thereof is very challenging and costly.

A cost-efficient solution was presented in WO 2019/215192 disclosing an optical sensor having a microlens structure comprising an array of microlenses for focusing desired light onto the pixels of a sensor array whereas undesired light is not detected. This solution was so compact that it could be integrated under a transparent display panel in an electronic device.

### Summary

A current trend within diode technology is a move towards organic light-emitting diodes, in particular driven by OLED light emitting panels, e.g. used for large television display panels. The hardware backbone of OLED light emitting panels can also be used for organic light receiving panels thereby driving down the cost of organic light receiving panels, i.e. organic sensors that are formed by arrays of organic photodiodes. But the pixel size within organic sensors is typically many times larger compared to e.g. CMOS or CCD sensors. The approach presented in WO 2019/215192 relies on each microlens focusing desired light to a corresponding pixel through a corresponding aperture, i.e. the optical setup is determined by the size of the pixel - and when the pixels become bigger, so the optical setup also grows in size. One purpose of the present disclosure is therefore to provide a compact optical sensor solution for use with imaging sensors having a relatively large pixel size.

The present disclosure is in many ways similar to the solution presented in WO 2019/215192 by disclosing an optical sensor system employing a microlens structure, comprising an array of microlenses, for focusing desired light onto the pixels of a sensor array whereas undesired light is not detected. The optical sensor system comprises a microlens structure having a front side with an array of light focusing elements and an opaque back side with an array of optically transparent apertures aligned with the focusing elements. A sensor array of optical detector pixels facing the back side of the microlens structure is also provided. The optical sensor system is configured such that light incident on the microlens structure, e.g. returned from an object on a display panel above the microlens structure, can be focused by the microlens structure onto the sensor array through the transparent apertures, i.e. the focal point of the light focusing elements (the microlenses) is on the pixels of the sensor array. But the presently disclosed optical sensor system is advantageously also configured such that each optical detector pixel receives light from a plurality of the light focusing elements. I.e. instead of one microlens focusing light to a single pixel or a group of pixels, the inventors have realized that a compact solution for large size pixels is to allow for many microlenses focusing light to single pixel. And the presently disclosed optical sensor system is therefore suitable for placement under a display panel for detecting and/or imaging light returned from an object, such as a fingerprint, on top of the display panel, even for large size pixels.

The microlens structure has a front side with an array of light focusing / image forming elements and an at least partially transparent back side. The back side may be provided with an array of optically transparent / light transmissive apertures, e.g. in the form of windows, aligned with the focusing elements. In the preferred embodiment it is only the apertures that are transparent whereas the remaining area of the back side is not light transmissive, e.g. opaque, i.e. light blocking, e.g. in the form of a light blocking layer, such that light cannot be transmitted through the opaque part of the back side of the microlens structure. Blocking light transmission can be provided by different means known in the art, such as an absorbing / light blocking colouring / reflective material or a certain roughness of the surface.

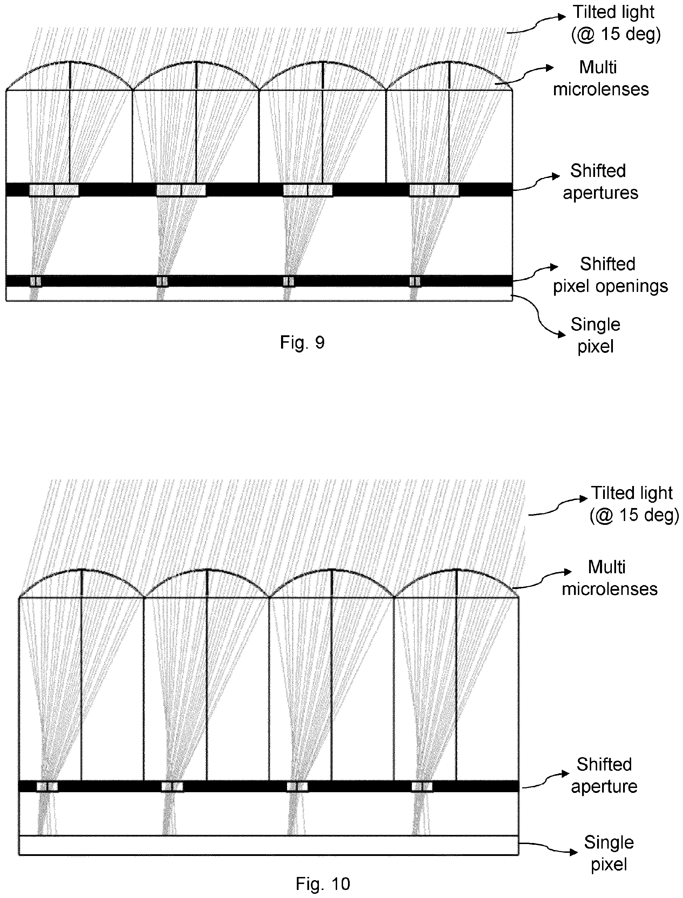

The presently disclosed optical sensor system is preferably configured such that light incident on the microlens structure within a predefined range of incident angles, is focused by the microlens structure to the sensor array whereas light incident on the microlens structure outside said predefined range of incident angles is not detected. Preferably each aligned pair of focusing element and aperture of the microlens structure directs the same predefined range of incident angles to the sensor array, as exemplified in figs. 9-12. The predefined range of incident angles may be less than 40 degrees, more preferably less than 30 degrees, yet more preferably less than 20 degrees, even more preferably less than 16 degrees, most preferably less than 10 degrees or even less than 6 degrees.

Pixel openings are usually a normal part of a detector array and the pixel opening layer is normally provided as a metal layer with apertures (i.e. pixel openings) provided just above the pixels - one pixel opening for each pixel. It is usually part of the specification and manufacture of the detector array and is provided to minimize the crosstalk between neighbouring pixels and normally the pixel opening is comparable in size to the pixel. In for example a CMOS detector with a pixel size of 12.5 microns the corresponding pixel opening can easily be 8-10 microns, i.e. such a large pixel opening does typically not have a large influence on the optical setup. The presently disclosed optical sensor system may or may not have an opaque layer, preferably metallic layer, forming a pixel opening layer above the optical detector pixels, with one pixel opening for each pixel, each pixel opening comparable in size with the corresponding pixel. However, in this case of large pixels and a plurality of microlenses for each pixel it has been found advantageous to make the configuration of the pixel openings part of the optical setup. The presently disclosed approach can therefore be further improved if the sensor array comprises an opaque layer above the optical detector pixels, the opaque layer having an array of optically transparent pixel openings, each pixel opening aligned with a corresponding light focusing element of the microlens structure. I.e. each pixel is associated with a plurality of pixel openings distributed in an array above the pixel and wherein the diameter of each pixel opening preferably is less than or equal to the diameter of the corresponding aperture - and thereby small compared to the size of the pixel. Each optical detector pixel preferably corresponds to a sub-array of the array of transparent pixel openings. The pitch of the pixel openings, i.e. the distance between neighbouring pixel openings, preferably equals the pitch of the apertures, i.e. the distance between neighbouring apertures, which typically equals the pitch of the focusing elements, i.e. the distance between neighbouring focusing elements.

The opaque layer (with pixel openings) of the sensor array is advantageously configured to block at least part of light incident on the microlens structure outside said range of incident angles, i.e. making the pixel openings function as a second aperture layer just above the pixels thereby further minimizing the detectable range of incident angles.

In case of an under display application, the presently disclosed optical sensor system may be configured to work with the display panel as the light source and/or with one or more separate light sources.

The present disclosure further relates to an image recognition device, such as a fingerprint sensor, comprising the presently disclosed optical sensor. The image recognition device may comprise a processing unit for processing the signal from the sensor array in order to recognize an image, e.g. detect a fingerprint. The image recognition device may further comprise a storage unit for storing image information, preferably in encrypted format. The processing unit, the storage unit and the sensor array may be part of one integrated circuit / component.

The present disclosure further relates to an ultra-compact imaging system, such as an ultrathin camera, incorporating the presently disclosed compact optical sensor system, which can capture high-contrast and high-resolution images without using any traditional and bulky lenses. It is particularly interesting for applications with flat panel detectors, where the pixel size is normally around 100 microns.

A further embodiment relates to an electronic device, such as smartphone, tablet, laptop, etc., for optically detecting a fingerprint, comprising a display panel comprising a top transparent layer formed over the display panel as an interface for being touched by a user, and the optical sensor which is disclosed herein.

The present disclosure further relates to a method for detecting and imaging light, comprising the steps of focusing and imaging light, incident on a microlens structure, to a sensor array of optical detector pixels by means of light focusing elements arranged in the microlens structure above the sensor array, wherein the light is received within a predefined range of incident angles and wherein each optical detector pixel receives light from a plurality of the light focusing elements.

The present disclosure further relates to a method for detecting light returned from an object on top of a display panel, comprising the steps of focusing and imaging light returned from the object to a sensor array of optical detector pixels by means of light focusing elements arranged in a microlens structure located below the display panel, wherein the fingerprint light is received within a predefined range of incident angles and wherein each optical detector pixel receives light from a plurality of the light focusing elements.

### Description of drawings

The accompanying drawings are included to provide a further understanding of the present disclosure and are incorporated in and constitute a part of this specification.
**Figs. 1A-D** illustrates how the presently disclosed approach can reduce the height of the optical setup by showing a comparison between small and large pixels.
**Fig. 2** shows a cut-through side view of four microlenses of a microlens structure arranged above corresponding apertures and pixel openings, all arranged above a single large pixel.

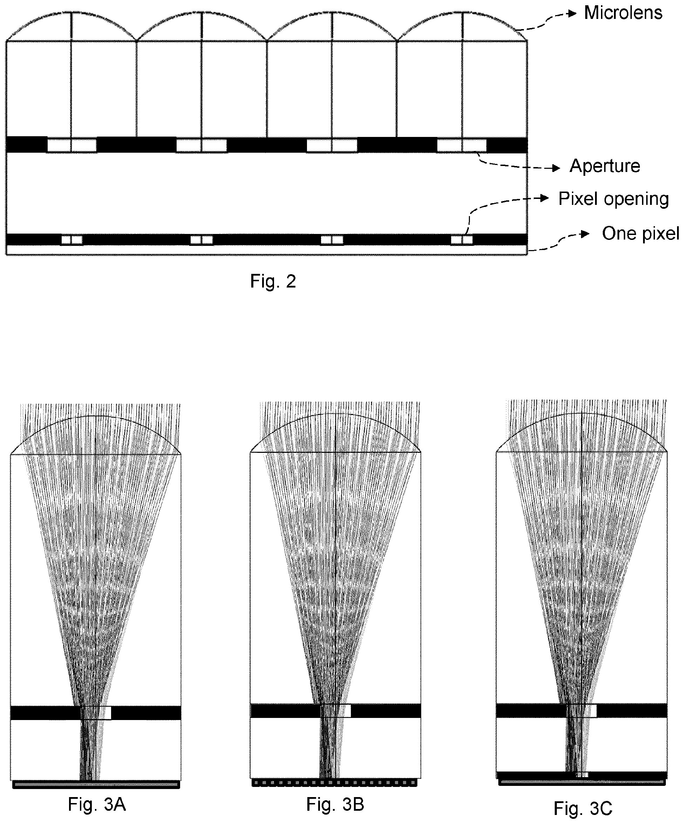

**Figs. 3A-B** show cut-through side view of an exemplary single microlens with a concave front surface and corresponding aperture as part of a microlens structure. Fig. 3A shows part of a large pixel below the aperture. Fig. 3B shows part of large pixel with a pixel opening in an opaque layer above the pixel, where the detected range of incident angle can be further minimized, compared to fig. 3A. Fig. 3C shows how a group of smaller pixels below the microlens can achieve angular filtering, without the use of a pixel opening. The setup in fig. 3C is not part of the presently disclosed detection approach because the pixels in fig. 3C do not receive light from a plurality of the microlenses.
**Fig. 4A** shows a perspective illustration of the front side of an array of microlenses.
**Fig. 4B** shows the back side of the microlens array in fig. 4A. The circles illustrate the transparent apertures. The remaining part of the back side is opaque.
**Fig. 4C** shows an example of pixel array with large pixels that correspond to the microlens array in figs. 4A-B. The black squares illustrate the pixels and each pixel corresponds to nine microlenses and corresponding nine apertures.
**Figs. 5A-B** shows a 3D perspective see-through view and the corresponding 2D cross-sectional view of one large pixel and the corresponding nine (3x3) microlenses, apertures and pixel openings.
**Figs. 6A-B** shows a 3D perspective see-through view and the corresponding 2D view of one large pixel and the corresponding sixteen (4x4) microlenses and apertures.
**Fig. 7** shows a 3D perspective see-through view of one large pixel and the corresponding sixteen (4x4) microlenses, apertures and pixel openings.
**Fig. 8** shows a cut-through side view of smartphone with an exemplary position of one embodiment of the presently disclosed compact optical sensor under the display of the phone.
**Fig. 9** shows an illustration of the functionality of one embodiment of the presently disclosed optical sensor with detection of light within a predefined range of incident angles around the inclination of 15 degrees employing pixel openings.
**Fig. 10** shows an illustration of the functionality of one embodiment of the presently disclosed optical sensor with detection of light within a predefined range of incident angles around the inclination of 15 degrees without employing pixel openings.
**Figs. 11A-C** illustrate an example, with the same principle as in fig. 9, that how light from different incident angles are either detected or blocked. The predefined range of incident angle is limited between about 12 and 18 degrees by both the aperture layer and pixel opening layer.
**Figs. 12A-C** illustrate an example, with the same principle as in fig. 10, that how light from different incident angles are either detected or blocked. The predefined range of incident angle is limited between about 10 and 20 degrees by only the aperture layer.

### Detailed description

A major advantage of the present invention is that the microlens structure can focus the desired light such that the light within the predefined incident angle range can be imaged to pixels on a sensor array. Compared to prior art solutions this means that more of the desired light is detected, i.e. the present microlens structure has a higher transmittance of the desired light. With more light to the detector an object can be detected faster and/or more precisely.

With the presently disclosed approach it is possible to use a similar detection principle and maintain a compact optical setup even though the pixels of the sensor array become much larger. This makes it possible to use the more cost-efficient organic sensor arrays where the pixel size typically is on the order of 50 µm and above.

As stated above each optical detector pixel is preferably aligned with a sub-array of said array of light focusing elements, e.g. a squared sub-array of said array of light focusing elements. I.e. the array of light focusing elements can be assembled in sub-arrays, and wherein each sub-array of light focusing elements is configured to focus and/or image light incident on the microlens structure to a single optical detector pixel on the sensor array.

In particular each optical detector pixel may be aligned with an integer of said light focusing elements, e.g. 4 (2×2), 16 (4×4), 36 (6×6), 64 (8×8) or 100 (10×10) of said light focusing elements, or 9 (3×3), 25 (5×5), 49 (7×7) or 81 (9×9) of said light focusing elements, i.e. corresponding to sub-arrays of the light focusing elements. One advantage of having an unequal square number of light focusing element corresponding to one pixel, is that the central light focusing element will then typically correspond to the centre of the pixel, where the light sensitivity typically is highest. The fill factor of a pixel is typically less than 100%, normally around 75%. Combined with sensitivity variation across the single pixel it is the centre portion that has the highest sensitivity. With a pixel size of for example 50 microns, it will typically be the centre portion within +/- 15 microns that has the highest sensitivity.

The size of the pixel, the size of the pixel area with highest sensitivity and the number of microlenses for each pixel influence the alignment tolerance between the sensor array and the microlens structure (and sub-arrays thereof), and an advantage of the presently disclosed approach is that more microlenses per pixel loosens this alignment tolerance, which can be translated into reduced cost of the sensor system. If for example a 50 micron pixel with a high sensitivity centre portion of +/- 15 microns is provided with a microlens structure where 4×4 microlenses correspond to each pixel, the period of the microlenses is 12.5 microns, i.e. much less than the high sensitivity centre portion of +/- 15 microns, and such a system will not be very sensitive to alignment. However, the alignment tolerance also depends on the existence of pixel openings and the configuration thereof. With similar or smaller pixel openings relative to the apertures, the pixel openings are part of the optical setup and the angular filtering and the alignment between the microlens structure and the sensor array becomes important. With no pixel opening layer or a pixel opening layer with large pixel openings, the sensitivity to alignments is loosened.

The pitch of the microlenses preferably correspond to the pitch of the apertures. And in case of one pixel opening for each aperture, the pitch of the pixel openings preferably correspond to the pitch of the apertures.

The microlens structure is preferably configured such that each light focusing element is capable of converging light incident on the microlens structure through a corresponding transparent aperture. In case of the use of an additional opaque layer with pixel openings the microlens structure may be configured such that each light focusing element is capable of converging light incident on the microlens structure through a corresponding transparent aperture and focusing on a corresponding pixel opening such that light is focused by the light focusing element to the detector array.

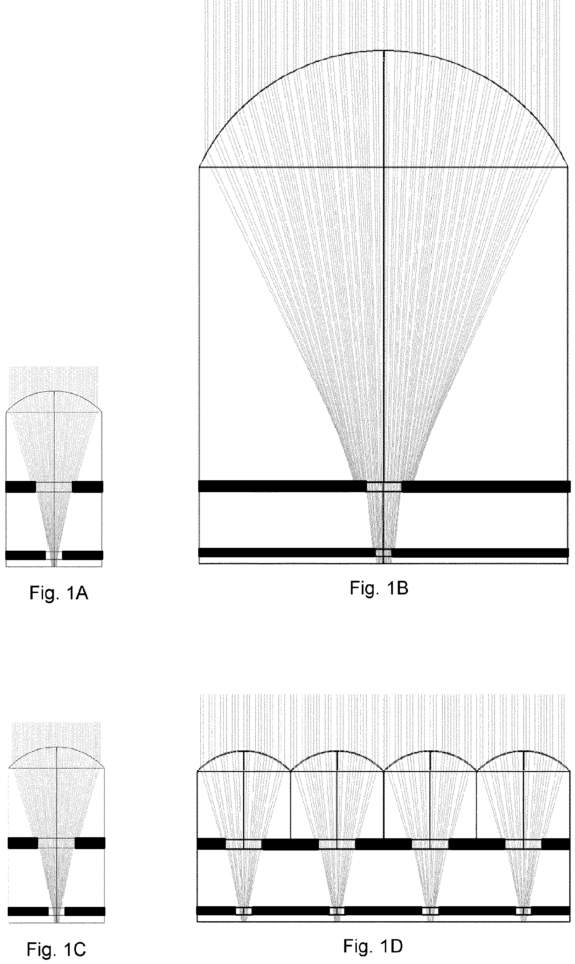

Each focusing element of the microlens structure can be customized to a certain optical design and configuration. The focusing elements can be spherical, aspherical, pyramid-shaped, convex, concave, etc. The design depends on the medium surrounding the microlens. For example, if the interface is air the focusing element would typically be spherical. If the interface is glue, the focusing elements would typically be aspherical. The back side of the microlens structure can be plane but could also be designed to help with focusing of the light, back focal length adjustment, aberration correction, etc. The size and design of the microlens structure and the focusing elements are also determined by the size of the pixel, and with larger pixels the steepness of the side of the focusing elements often increases, compare for example figs. 1A and 1B. This reduces the light transmittance at the sides of each light focusing element. Hence, the presently disclosed approach can maintain a high light transmittance because the light focusing elements can be kept small even when the pixels become large.

In order to reduce the cost the present microlens structure is preferably manufactured such that all focusing elements are identical.

As stated previously the microlens structure may comprise a back side where through light can be transmitted. In a preferred embodiment it is not the entire back side of the microlens array that is transparent but only transparent apertures, such as an array of transparent apertures, that correspond to the array of focusing element. The remaining part of the back side can be made opaque. The transparent apertures are exemplified in the figures. The microlens structure is preferably configured such that each of said focusing elements is in optical correspondence with one of said transparent apertures. These transparent apertures help to ensure that only light within the predefined incident angle range is transmitted to the sensor array. Undesired light can for example be scattered or absorbed such that it does not hit the detector / sensor array. The microlens structure may for example be configured to absorb or scatter at least part of the light having an incident angle outside of the predefined angle range. E.g. the microlens structure can be configured to be light absorbing except for the front side with the focusing elements and the transparent apertures which are light transmissive. This can for example be provided by applying a dark colour to the surface part of the microlens structure which should be light absorbent. Opacity can also be provided by roughening the back side surface. Another solution is to make the back side surface at least partly reflective, e.g. by covering at least a part of the back side surface with an at least partly reflective material.

In the preferred embodiment of the presently disclosed optical sensor is configured such that light is focused and imaged to the sensor array. Hence, the microlens structure may be configured such that each focusing element is capable of converging light through a corresponding transparent aperture of the back side of the microlens structure. Focusing may for example be provided by providing at least a part of or all of the focusing elements with a spherical surface.

In the preferred embodiment there is no interface between the individual microlens elements in the microlens structure, the bulk inside the microlens is preferably a solid uniform block of a transparent material. The optical properties of the presently disclosed optical sensor could be improved if the side surfaces, i.e. the surfaces connecting the front and back sides, of each individual microlens element were opaque such that undesired light could be absorbed by the side surfaces. However, that would make the microlens structure much more complicated and expensive to manufacture. Instead the optical properties can be controlled by the apertures, and optionally the pixel openings, which can be cost-efficiently designed and manufactured.

The sensor array may be a standard CCD/CMOS sensor array. A typical pixel size of a standard CMOS array is 10-15 µm or even less. However, the presently disclosed principle really becomes an advantage when moving to larger pixels, i.e. above 20 µm and larger, for example around 50 µm or above, which is the typical size of an organic sensor.

The presently disclosed optical sensor can be optically designed to match a predefined display panel where the distance from the touch surface to the microlens structure provides an optical constraint for the design of the microlens structure and the sensor array. With a standard off-the-shelf sensor array, e.g. an organic sensor array, the pixel size is predefined which provides another optical constraint. With a customized sensor array the pixel size can be part of the optical design space.

The presently disclosed optical sensor may be configured to utilize light from a light emitting display panel, e.g. a display panel of an electronic device, e.g. by using the OLED light sources that typically are part of a display panel.

Another solution is to provide at least one (separate) light source for transmitting light such that light is transmitted out from the touch surface where the fingerprints will be located. The light source(s) may advantageously be configured for emitting infrared light, such as around 700-900 nm or 800-900 nm, alternatively or additionally green light. However, other wavelength ranges are possible. The light source may at least one laser or LED which can be provided very cost efficiently and very compact. There are many solutions to integrate one or more light sources such that light is transmitted out from the touch surface.

In the preferred embodiment the microlens structure is manufactured in a polymeric material, such as PMMA or PC, preferably by injection moulding or film pressing. The microlens structures can be manufactured in large units, each unit comprising a plurality of microlens structures. The individual microlens structures for use in an optical sensor can then be provided by cutting the large units into smaller structures.

The transparent apertures can be provided by painting the back side of the microlens structure in an absorbing colour, preferably a dark colour such as black, except for the apertures thereby forming the transparent apertures. Painting can be provided by means of printing on the microlens structure, e.g. with the combination of a mask. The transparent apertures can be any geometric form, but a circular structure is the preferred for optical imaging reasons. The transparent apertures may advantageously have an area of less than 800 µm², more preferably less than 400 µm², more preferably less than 200 µm², most preferably less than or around 100 µm². I.e. the apertures may be circular / cylindrical.

The transparent apertures can also be provided by making at least a part of the back side of the microlens structure at least partly reflective, such as fully reflective or partly reflective, partly absorptive. This can be provided by attaching a reflective material to the back side of the microlens structure, where reflective material has been attached to the back side of the microlens structure, i.e. below the microlens structure, to create the transparent apertures between the reflective material elements. The advantage of this solution is that light incident on the reflective back side can be reflected back towards the display panel and thereby be used for illuminating an object such as a fingerprint on the display panel. I.e. less photons are wasted due to absorption in the microlens structure but can be reused for illumination thereby increasing the utilization of the light source and improving the efficiency of the device.

In one embodiment of the present disclosure a reflective back side of the microlens structure is provided by means of a metal, such as a metal foil, such as an aluminium foil, which can be attached to the back side of the microlens structure. The transparent apertures can be provided by cutting and/or stamping holes in the metal foil such that correspondence is provided with the individual microlenses of the microlens structure.

In one embodiment of the presently disclosed optical sensor, the distance between the front side and the back side of the microlens structure is less than 400 µm, more preferably less than 300 µm, even more preferably less than 200 µm, yet more preferably less than 100 µm, even more preferably less than 75 µm, yet more preferably less than 60 µm, most preferably less than 55 µm. The focusing elements, i.e. the microlenses, of the microlens structure may have a diameter of less than 100 µm, more preferably less than 50 µm, even more preferably less than 30 µm, most preferably less than or around 25 µm. The individual focusing elements may be configured to have a back focal length of less than 30 µm, more preferably less than 20 µm, more preferably less than 15 µm, most preferably less than or approx. 10 µm. Hence, the footprint of the microlens structure in the plane of the sensor array may therefore be less than 400 mm², more preferably less than 200 mm², most preferably less than or around 100 mm².

The total height of the presently disclosed optical sensor may consequently be less than 500 µm, more preferably less than 300 µm, more preferably less than 200 µm, even more preferably less than 150 µm, most preferably less than 100 µm.

The optical sensor may substantially square or rectangular. However, a substantially elongated embodiment is also an option such that the sensor becomes a line scanner.

### Lens properties

As used herein, a lens (e.g. a microlens) include, but are not limited to elements with a cross-sectional structure that is hemispherical, aspherical, conical, triangular, rectangular, polygonal, or a combination thereof along a plane perpendicular to the microlens structure of the lens through the centre of the lens.

The lens may have optical properties such that it is substantially transparent to at least the light returned from an object. Further, the lens may have a refractive index above 1, preferably at least 1.1, more preferable at least 1.2, even more preferable at least 1.25, most preferable at least above 1.25. Preferably collimated incident light is focused by the microlens into a single point located in the focal plane of the microlens.

In an additional embodiment of the present disclosure the lenses are lenticular lenses, such as linear lens arrays and/or two-dimensional lens arrays such as close-packed hexagonal or any other two-dimensional array. The apertures of a microlens structure employing lenticular lenses may be, but are not limited to, the use of slits instead of pinhole apertures. In further embodiments of the present disclosure, the apertures have other shapes such as rectangular, such as a square, oval or polygonal.

### Examples

**Figs. 1A-D** illustrates how the presently disclosed approach can reduce the height of the optical setup by showing a comparison between small and large pixels.

**Fig. 1A** shows a cut-through side view of an exemplary single focusing element (a microlens) of a microlens structure and a corresponding pixel. In between the microlens and the pixel is an opaque layer with an aperture, and just on top of the pixel is an opaque layer with a pixel opening. The focusing element at the front side of the microlens focuses light on to the pixel by means of a convex front surface. The convex front surface functions as focusing element when located in a medium with lower refraction index than itself, such as air. A wavefront with an incident angle of 0° is incident on the microlens. Desired light pass through the aperture and the pixel opening before hitting the pixel which is an optical detector. Undesired light is absorbed and/or reflected by the opaque layers and/or or hit outside of the pixel.

The front side of the microlens in fig. 1A is a sphere with radius of curvature of 8.5 microns. The height of the microlens is 11.8 microns, width and length are both 12.5 microns. The back focal length is 22.5 microns. The total height of the sensor is 24 microns. The transparent aperture in the center of the back side is circular. The size of the corresponding pixel is 12.5 × 12.5 microns.

The optical principle in **fig. 1B** corresponds exactly to the setup fig. 1A, however in fig. 1B the width of the pixel has been made four times larger. I.e. if the pixel (50 × 50 microns) is square the areal size of the pixel in fig. 1B is sixteen times larger than the areal size of the pixel in fig. 1A. With a four times wider pixel size, the size of a single microlens covering a single pixel must also be scaled, and the radius of curvature becomes 28 microns and the total height of the sensor increases to 71 microns. I.e. the comparison between figs.1A and 1B corresponds to switching from a CMOS sensor with a typical pixel size of 12.5 × 12.5 microns (fig. 1A) to an organic sensor with a typical pixel size of 50 × 50 microns (fig. 1B).

**Fig. 1C** corresponds to fig. 1A, whereas **fig. 1D** illustrates how the presently disclosed approach makes switching to larger pixels possible without sacrificing compactness of the sensor. Fig. 1D has a single large pixel with the same size as in fig. 1B. However, instead of having a single microlens collecting all the light for one pixel, fig. 1D illustrates four microlenses side by side cooperating to collect light to a single pixel. Actually it is 4 × 4 = 16 microlenses that is used to collect light to the single large pixel, but as fig. 1D is a cross-sectional 2D view, only four of them are shown. As also shown in figs. 1A-C, fig. 1D has an opaque layer forming a back side of the microlens structure with an aperture for each microlens, and an opaque layer on top of the single large pixel with pixel opening corresponding to the apertures and microlenses. As in figs. 1A-C a wavefront with an incident angle of 0° is incident on the microlenses in fig. 1D, and desired light pass through the apertures and the pixel openings before hitting the single large pixel. I.e. the optical filtering principle still applies and desired light is focused by the microlenses onto the detector, whereas undesired light is absorbed and/or reflected by the opaque layers and/or or hit outside of the pixel. Compared with fig. 1B, the presently disclosed approach, as exemplified in fig. 1D, can not only maintain the compactness of the whole sensor, but also avoid the low optical efficiency at the very steep surfaces toward the edges of the microlens in fig. 1B due to the increased radius of curvature of the microlens in fig. 1B.

**Fig. 2** is similar to fig. 1D, however without the wavefront of light incident on the microlenses. It shows a cut-through side view of four microlenses of a microlens structure arranged above corresponding apertures and pixel openings, all arranged above a single large pixel.

**Figs. 3A-C** show cut-through side views of an exemplary single microlens with a convex front surface and corresponding aperture as part of a microlens structure. Figs. 3A-B are included to illustrate the advantage of having small pixel openings, whereas fig. 3C provides an alternative to a small pixel opening. In all of figs. 3A-C a wavefront with incident angles of 0°, 2° and 4° (with different colors) is incident of the microlens. Fig. 3A shows part of a large pixel below a single microlens, and the opaque layer with the aperture is seen to filter all the light with the incident angle larger than 4°. Fig. 3B also shows part of a large pixel, but with a pixel opening in an opaque layer above the pixel, i.e. fig. 3B corresponds to a section of fig. 2 with only one of the microlenses. As seen from fig. 3B the opaque layer with the pixel opening functions blocks even more light thereby functioning as an additional filter. In fig. 3C a group of smaller pixels is provided below a single microlens. The setup in fig. 3C is not part of the presently claimed detection approach because the pixels in fig. 3C do not receive light from a plurality of the microlenses - in contrast the light from a single microlens is received by a plurality of pixels. From fig. 3C it can be seen that the additional filtering provided by the pixel opening in fig. 3B can be achieved by the setup in fig. 3C by selectively enabling only some of the pixels below the microlens. Therefore, in combination with an aperture layer, an additional angular filtering effect can be achieved by either having a group of small pixels, as in fig. 3C, or applying pixel openings on top of the pixel, as in fig. 3B. However, in the presently disclosed detection approach which in particular applies to large pixels, the setup in fig. 3B is the preferred choice.

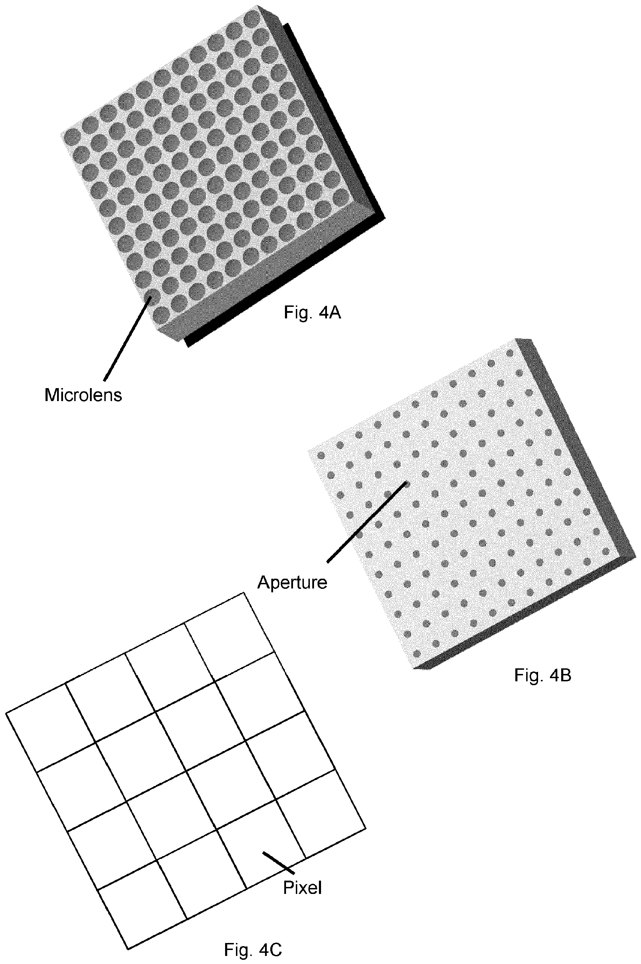

**Fig. 4A** shows a perspective illustration of a plurality of the microlenses in fig. 3 arranged in an array forming part of a microlens structure in front of a pixel array. As a practical implementation typically comprises many thousands of microlenses the illustrated array of 121 microlenses is only a very small part of an actual microlens structure.

**Fig. 4B** shows the back side of the microlens array in fig. 4A. The circles illustrate the transparent apertures. The remaining part of the back side is opaque. The example in fig. 4B shows circular fronts, but other options are possible, e.g. hexagonal, triangular, etc. As long as an area can be formed.

**Fig. 4C** shows an example of pixel array with large pixels (squares) that correspond to the microlens + aperture arrays in figs. 4A-B. The black squares illustrate the pixels and each pixel corresponds to nine microlenses and corresponding nine apertures, i.e. each of the pixels in fig. 4C receives light from nine microlenses through nine corresponding apertures.

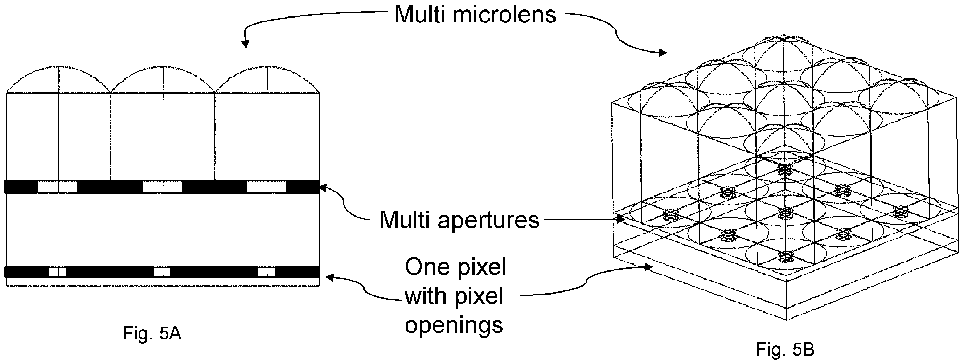

**Figs. 5B** to the right shows a 3D perspective see-through view, whereas **fig. 5A** shows the corresponding 2D cross-sectional view of one large pixel and the corresponding nine (3x3) microlenses, apertures and pixel openings.

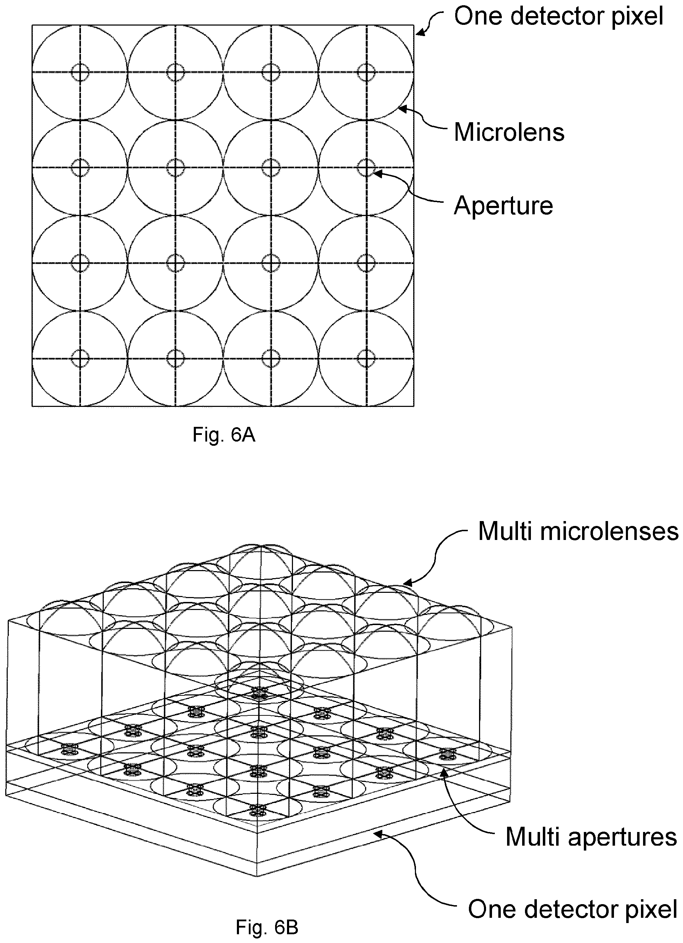

**Figs. 6B** shows a 3D perspective see-through view, whereas **fig. 6A** shows the corresponding 2D to view of one large pixel and the corresponding sixteen (4x4) microlenses and apertures. The setup in fig. fig. 6B does not have pixel openings.

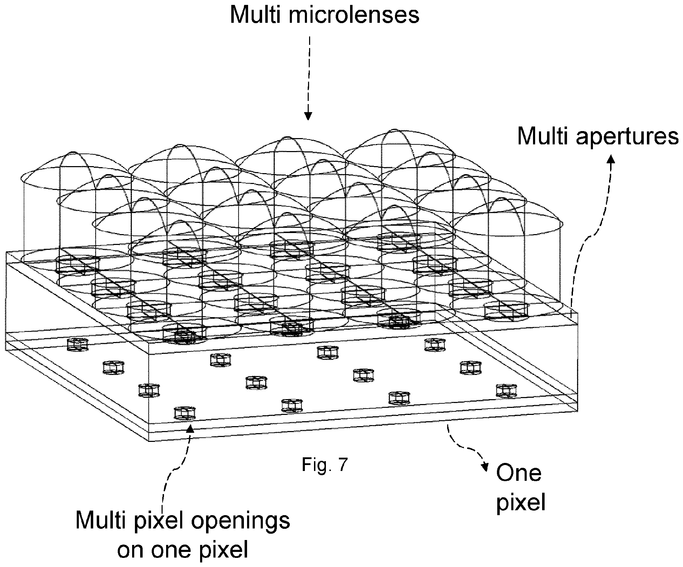

**Fig. 7** shows a 3D perspective see-through view of one large pixel and the corresponding sixteen (4x4) microlenses, apertures and pixel openings.

Comparing fig. 5 with figs. 6-7 it is seen that in the 3×3 multi-microlens setup there will be a microlens and a corresponding apertures that is located right above the center of the pixel, which typically is the most light sensitive part of the pixel. In that regard multi-microlens setups with an unequal number of microlenses, e.g. 3×3, 5×5, 7×7, 9×9, etc., may be preferred because the center part of the pixel is illuminated.

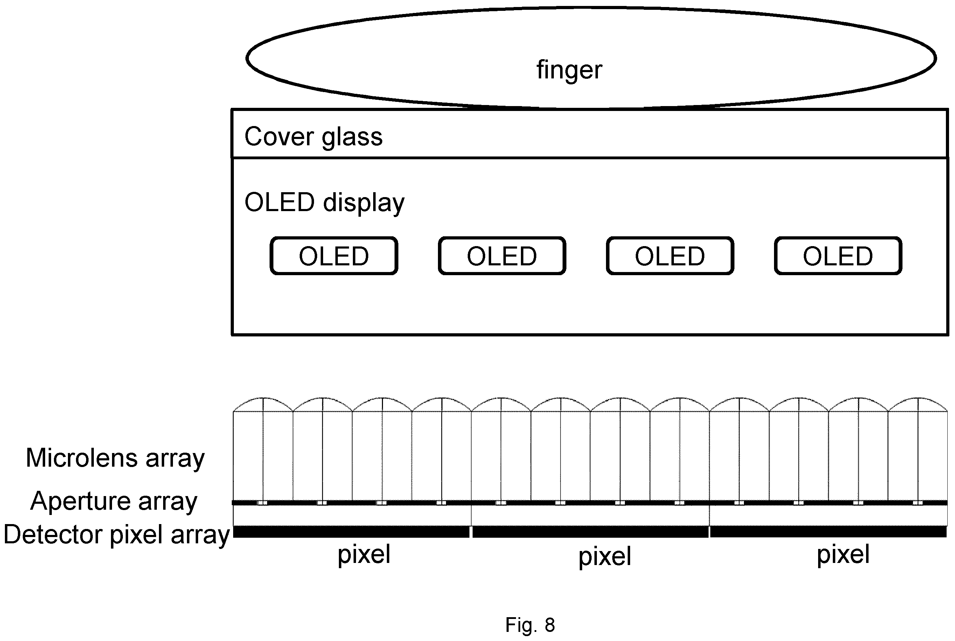

**Fig. 8** shows a cut-through side view of smartphone with an exemplary position of one embodiment of the presently disclosed compact optical sensor with 4×4 multi-microlens setup under the display of the phone, where the cover glass located above an OLED display is being touched by a finger. The compact optical sensor, here functioning as a fingerprint sensor, is located below the OLED display. The sizing in fig. 8 is not shown realistically because the presently disclosed compact optical sensor detector will typically be much thinner than a display panel + cover glass.

**Fig. 9** shows an illustration of the functionality of one embodiment of the presently disclosed optical sensor with a 4x4 multi-microlens setup. A wavefront of light with 15° incident angle, i.e. tilted light, is incident on the microlens array. The incident angle of light incident on the microlens structure is determined relative to the normal to the plane defined by the extension of the microlens structure, i.e. the vertical plane in fig. 9. The light is focused by the microlenses. The apertures are shifted off-centre relative to the microlenses such that the tilted light pass through the apertures. The pixels openings are also shifted off-centre such that the incoming light with 15° incident angle passes through the pixel openings and are focused to the single large pixel. This is especially an interesting implementation for the applications where the strongest part of the signal is at a tilted angle instead of 0 degree or in the case that the sensor is intentionally designed to detect a signal/take an image from other directions than 0 degree. Hence, incoming light with a range of incident angles around a non-zero incident angle can be focused onto the detector array, whereas light outside of this range of incident angles is not detected, e.g. it is blocked by the opaque layer with the apertures and/or it is blocked by the opaque layer with the pixel openings. I.e. the focusing elements in the form of the microlenses are the same as in fig. 6, which is arranged for detection of incident angles around 0°, but the apertures and pixel openings in fig. 9 are moved off-centre such that it is light with an incident angle around 15° that is detected. In fig. 9 it is seen that the focusing elements, the apertures and the pixel openings are arranged to be off-centre relative to each other as in fig. 9, but that the pitch of the focusing elements equals the pitch of the apertures which equals the pitch of the pixel openings. Thereby each aligned pair of focusing element and aperture of the microlens structure (and corresponding pixel opening) directs the same predefined range of incident angles to the sensor array. If the focusing elements, the apertures (and optionally) the pixel openings were arranged off-centre relative to each other and with the pitch of the focusing elements different from the pitch of the apertures, i.e. different pitches or even varying pitches of one or both of them, the focusing elements and the apertures would not be aligned and pairs of focusing element and aperture of the microlens structure (and optionally corresponding pixel opening) would direct light from different ranges of incident angles to the sensor array, as exemplified in US 2009/0179142.

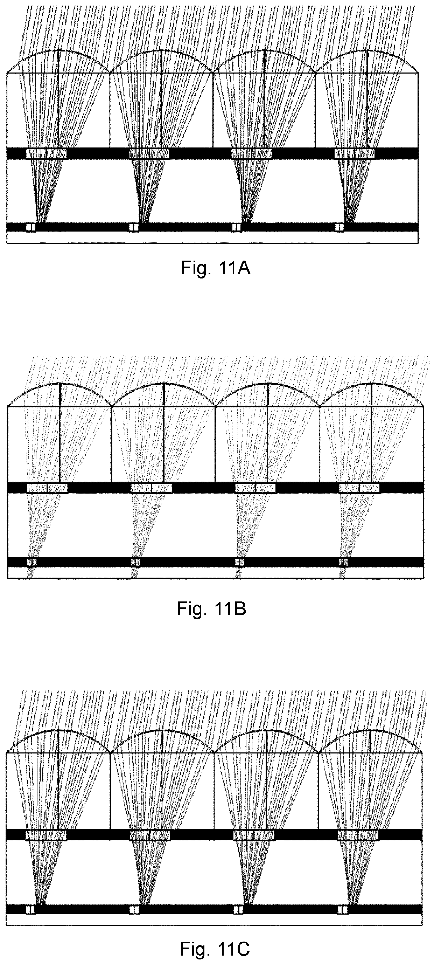

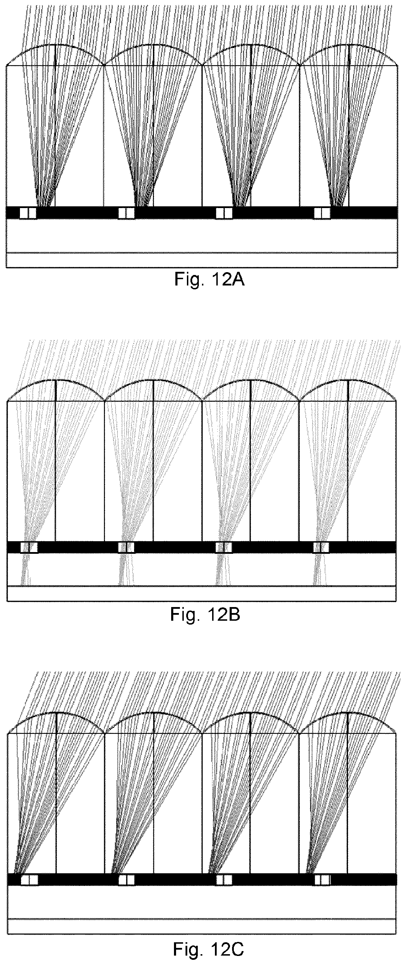

**Fig. 10** corresponds to fig. 9, i.e. a wavefront of light with 15° incident angle is incident on the microlens array and as in fig. 9 the apertures are shifted to be off-centre. As already discussed above in relation to fig. 3, even though no pixel openings are provided in fig. 10, a certain degree of angular filtering can still be achieved. The incoming light with a range of incident angles around the 15° incident angle is focused onto the detector array, whereas light outside of this range of incident angles is not detected, e.g. it is absorbed by the opaque layer with the off-centre apertures. Comparing fig. 10 with fig. 9 both the position, the diameter and the thickness of the aperture have to be tuned in order to achieve the angular filtering effect. It is also seen that the light filtering is more efficient in fig. 9. A further detailed comparison is presented in Figs. 11 and 12. Depending on the required resolution for the sensor and the complication of the structures, one can for example design the presently disclosed compact optical sensor in one of the configurations of fig. 9 or fig. 10.

**Figs. 11A-C** illustrate the same principle as in fig. 9. Wavefronts of light with tilted incident angles (fig. 11A: 11° incident angle, fig. 11B: 15° incident angle, fig. 11C: 19° incident angle) are incident on the microlens array and the light is focused by the microlenses. The apertures are shifted off-centre relative to the microlenses, but the apertures are large enough in all figs. 11A-C such that the tilted light pass through the apertures. The pixels openings are also shifted off-centre, but the size of the pixel openings are selected such that only incoming light around 15° incident angle in fig. 11B passes entirely through the pixel openings and are focused to the single large pixel, whereas the 11° light in fig. 11A and the 19° light in fig. 11C are at the very boundary of the incident angle range and hence blocked by the opaque layer with pixel openings. Therefore, the incident angle range for this tilted configuration is 15°± 3°.

**Figs. 12A-C** illustrate the same principle as in figs. 10-11. Wavefronts of light with tilted incident angles (fig. 12A: 9° incident angle, fig. 12B: 15° incident angle, fig. 12C: 21° incident angle) are incident on the microlens array and the light is focused by the microlenses. The apertures are shifted off-centre relative to the microlenses, but the apertures are smaller and closer to the pixel, compared to the apertures in fig. 11, such that only light with 15° incident angle passes through to the detector, whereas the 9° light in fig. 12A and the 21° light in fig. 12C is blocked by the opaque layer with apertures. I.e. with a suitable configuration of the aperture layer, a similar filtering effect can be obtained with only one opaque layer with apertures without the use of an opaque layer with pixel openings. But, the incident angle range for this tilted configuration is 15°± 5°, which is larger than in fig. 11.

### Items

1. An optical sensor system comprising
   - a microlens structure having a front side with an array of light focusing elements and an opaque back side with an array of optically transparent apertures aligned with the focusing elements, and
   - a sensor array of optical detector pixels facing the back side of the microlens structure,
   the optical sensor system is configured such that 1) light incident on the microlens structure can be focused by the microlens structure onto the sensor array through the transparent apertures, and 2) each optical detector pixel receives light from a plurality of the light focusing elements.
2. The optical sensor system according to item 1, wherein the optical sensor system is configured such that light incident on the microlens structure within a predefined range of incident angles is focused by the microlens structure to the sensor array whereas light incident on the microlens structure outside said predefined range of incident angles is not detected.
3. The optical sensor system according to item 2, wherein each aligned pair of focusing element and aperture of the microlens structure directs the same predefined range of incident angles to the sensor array.
4. The optical sensor system according to any of items 2-3, wherein the predefined range of incident angles is 40 degrees, more preferably 30 degrees, yet more preferably 20 degrees, even more preferably 16 degrees, most preferably 10 degrees or even 6 degrees.
5. The optical sensor according to any of the preceding items, wherein the pitch of the focusing elements equals the pitch of the apertures.
6. The optical sensor according to any of the preceding items, wherein the sensor array comprises an opaque layer above the optical detector pixels, the opaque layer having an array of optically transparent pixel openings.
7. The optical sensor according to item 6, wherein each pixel comprises only one pixel opening.
8. The optical sensor according to item 6, wherein each pixel comprises a plurality of pixel openings.
9. The optical sensor system according to 8, wherein the diameter of each pixel opening is less than or equal to the diameter of the corresponding aperture.
10. The optical sensor system according to any of the preceding items 8-9, wherein each optical detector pixel corresponds to a sub-array of the array of transparent pixel openings.
11. The optical sensor system according to any of the preceding items 8-10,
   wherein the pitch of the pixel openings equals the pitch of the apertures.
12. The optical sensor system according to any of the preceding items 8-11,
   wherein the opaque layer of the sensor array is configured to block at least part of the light incident on the microlens structure outside said range of incident angles.
13. The optical sensor according to any of the preceding items, wherein each optical detector pixel coincides with a plurality of the light focusing elements.
14. The optical sensor according to any of the preceding items, wherein each optical detector pixel is aligned with a sub-array of said array of light focusing elements.
15. The optical sensor according to any of the preceding items, wherein each optical detector pixel is aligned with a squared sub-array of said array of light focusing elements.
16. The optical sensor according to any of the preceding items, wherein each optical detector pixel is aligned with an integer of said light focusing elements.
17. The optical sensor according to any of the preceding items, wherein each optical detector pixel is aligned with 9, 25, 49 or 81 of said light focusing elements.
18. The optical sensor according to any of the preceding items, wherein each optical detector pixel is aligned with 4, 16, 36, 64 or 100 of said light focusing elements.
19. The optical sensor system according to any of the preceding items, wherein the microlens structure is configured to block at least part of the light incident on the microlens structure outside said range of incident angles.
20. The optical sensor according to any of the preceding items, wherein the array of light focusing elements are assembled in sub-arrays, and wherein each sub-array of light focusing elements is configured to focus and/or image light incident on the microlens structure to a single optical detector pixel on the sensor array.
21. The optical sensor according to any of the preceding items, wherein the microlens structure is configured such that each light focusing element is capable of converging light incident on the microlens structure through a corresponding transparent aperture.
22. The optical sensor according to any of the preceding items 6-21, wherein the microlens structure is configured such that each light focusing element is capable of converging light incident on the microlens structure through a corresponding transparent aperture and corresponding pixel opening and focusing on the pixel below the pixel opening.
23. The optical sensor according to any of the preceding items, wherein the sensor array is an organic sensor, such as an array of organic photodiodes, TFT flat panel detector, CCD, CMOS and/or an array of photodiodes.
24. The optical sensor system according to any of the preceding items, wherein the size of each optical detector pixel is at least 12 µm × 12 µm, more preferably at least 25 µm × 25 µm, more preferably at least 40 µm × 40 µm, most preferably at least 50 µm × 50 µm, such as 50.8 µm × 50.8 µm.
25. The optical sensor system according to any of the preceding items, wherein the distance between the front side and the back side of the microlens structure is less than 100 µm.
26. The optical sensor system according to any of the preceding items, wherein the focusing elements have a diameter of less than 30 µm.
27. The optical sensor system according to any of the preceding items, wherein the focusing elements is configured to have a back focal length of less than 30 µm.
28. The optical sensor system according to any of the preceding items, wherein each aperture in the microlens structure has an area of less than 200 µm².
29. The optical sensor system according to any of the preceding items 6-28,
   wherein each pixel opening has an area of less than 30 µm².
30. The optical sensor system according to any of the preceding items, configured to utilize light from a light emitting display panel.
31. The optical sensor system according to any of the preceding items, suitable for placement under a display panel for detecting and/or imaging light returned from an object on top of the display panel.
32. An image recognition device, such as a fingerprint detector, comprising an optical sensor system according to any of preceding items, a storage unit for storing image information and a processing unit for processing the signal from the sensor array in order to recognize an image.
33. An electronic device for optically detecting a fingerprint, comprising
   - a display panel comprising a top transparent layer formed over the display panel as an interface for being touched by a user, and
   - an optical sensor according to any of preceding items.
34. A method for detecting light returned from an object on top of a display panel, comprising the steps of
   - focusing and imaging light returned from the object to a sensor array of optical detector pixels by means of light focusing elements arranged in a microlens structure located below the display panel, wherein the fingerprint light is received within a predefined range of incident angles and wherein each optical detector pixel receives light from a plurality of the light focusing elements.

## Claims

1. An optical sensor system comprising
- a microlens structure having a front side with an array of light focusing elements and an opaque back side with an array of optically transparent apertures aligned with the focusing elements, and
- a sensor array of optical detector pixels facing the back side of the microlens structure,
the optical sensor system is configured such that 1) light incident on the microlens structure can be focused by the microlens structure onto the sensor array through the transparent apertures, and 2) each optical detector pixel receives light from a plurality of the light focusing elements.

2. The optical sensor system according to claim 1, wherein the optical sensor system is configured such that light incident on the microlens structure within a predefined range of incident angles is focused by the microlens structure to the sensor array whereas light incident on the microlens structure outside said predefined range of incident angles is not detected.

3. The optical sensor system according to claim 2, wherein each aligned pair of focusing element and aperture of the microlens structure directs the same predefined range of incident angles to the sensor array and wherein the predefined range of incident angles is less than 10 degrees, preferably less than 6 degrees.

4. The optical sensor according to any of the preceding claims, wherein the sensor array comprises an opaque layer above the optical detector pixels, the opaque layer having an array of optically transparent pixel openings.

5. The optical sensor according to claim 4, wherein each pixel comprises only one pixel opening.

6. The optical sensor according to claim 4, wherein each pixel comprises a plurality of pixel openings and wherein the diameter of each pixel opening is less than or equal to the diameter of the corresponding aperture and wherein the opaque layer of the sensor array is configured to block at least part of the light incident on the microlens structure outside said range of incident angles.

7. The optical sensor system according to claim 6, wherein each optical detector pixel corresponds to a sub-array of the array of transparent pixel openings.

8. The optical sensor system according to any of the preceding claims 6-7, wherein the pitch of the pixel openings equals the pitch of the apertures which equals the pitch of the focusing elements.

9. The optical sensor according to any of the preceding claims, wherein each optical detector pixel is aligned with a sub-array of said array of light focusing elements.

10. The optical sensor according to any of the preceding claims, wherein each optical detector pixel is aligned with 4, 9, 16, 25, 36, 49, 64, 81 or 100 of said light focusing elements.

11. The optical sensor according to any of the preceding claims, wherein the array of light focusing elements are assembled in sub-arrays, and wherein each sub-array of light focusing elements is configured to focus and/or image light incident on the microlens structure to a single optical detector pixel on the sensor array.

12. The optical sensor according to any of the preceding claims 4-11, wherein the microlens structure is configured such that each light focusing element is capable of converging light incident on the microlens structure through a corresponding transparent aperture and corresponding pixel opening and focusing on the pixel below the pixel opening.

13. The optical sensor according to any of the preceding claims, wherein the sensor array is an organic sensor, such as an array of organic photodiodes.

14. The optical sensor system according to any of the preceding claims, wherein the size of each optical detector pixel is at least 40 µm × 40 µm, most preferably at least 50 µm × 50 µm, such as 50.8 µm × 50.8 µm.

15. The optical sensor system according to any of the preceding claims, suitable for placement under a display panel for detecting and/or imaging light returned from an object, such as a fingerprint, on top of the display panel.
